# EUROPEAN PATENT APPLICATION

(11) **EP 1 622 265 A1**
(43) Date of publication of application: **01.02.2006**
(21) Application number: 05016550.5
(22) Date of filing: 29.07.2005
(51) Int. Cl.: H03H 17/02

(54) **Digital filter device**

(30) Priority: 30.07.2004 IT BO20040487
(71) Applicant: Teko Telecom S.R.L., 40068 San Lazzaro Di Savena BO (IT)
(72) Inventor: Dalla Palma, Luca, 11017 Morgex (AO) (IT); Durante, Davide, 18027 Pontedassio (IM) (IT); Gristina, Giuseppe, 05010 Porano (TR) (IT); Sereni, Euro, 06078 Ponte Valleceppi (PG) (IT); Vagheggini, Michele, 06100 Frazione San Sisto (PG) (IT)
(74) Representative: Negrini, Elena

(57) **Abstract**

A filter device comprises at least:
- a first analog to digital signal converter (2) provided with a analog signal input port (3) having a predetermined maximum frequency and with an output port (4) for the signal converted in digital format;
- a numeric processing unit (5) provided with a respective input port (6) in data communication with the output port (4) for the digital converted signal and with a respective output port (7) for the elaborated digital signal;
- a second digital to analog signal converter (8) provided with an input port (9) for the digital signal elaborated and with an output port (10) for the signal converted into analog format.

The numeric processing unit (5) elaborate the digital signal to attenuate or to eliminate the components with frequency lower than a first determined minimum threshold and/or the components with frequency higher than a second determined maximum threshold.

## Description

The present invention refers to the technical field of signal treatment devices and refers to a digital filter, particularly for professional broadcasting apparatuses such as radio, analog and/or digital television and the others utilizations for the telecommunications.

There are known acoustic filter devices with surface propagation on a crystal structure commonly called SAW filter.

Such known filter, despite of the remarkable performances due to its form factor, has the drawback of a high attenuation and to introduce a big delay of the signal passes there through. Their amplitude and delay values range from -15 dB to -30 dB and 3 µS to 5 µS; the variation depends on the technology and the different passing bands that the manufactures use for various purposes in the telecommunication apparatuses.

Other drawbacks of such known filter devices consist in the fact that their form factors are not adjustable and depending from the band of the signal.

An object of the present invention is to propose a filter device almost without attenuation and with a very small propagation delay.

Other object is to propose a filter device with adjustable form factor and independent from the band and that is able to equalize the variations of amplitude and the transit time of the signal.

Further object is to propose a device does not need frequency conversions or frequency transpositions or analog demodulations of the signal.

The above mentioned objects are achieved according to the content of the claims.

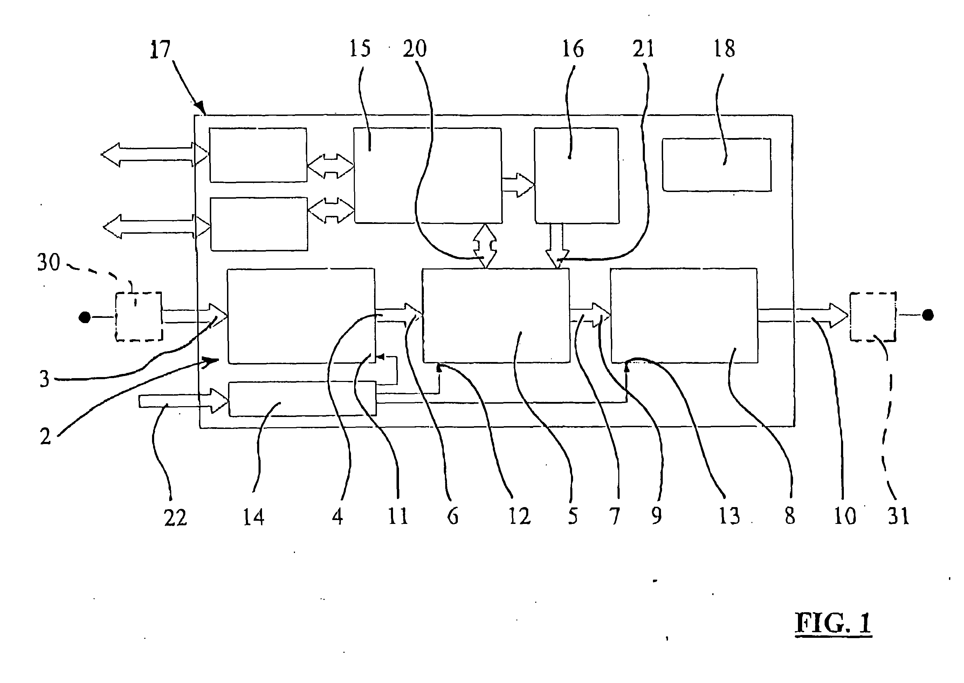

The characteristics of the invention are highlighted in the following with particular reference to the attached drawing, in which the figure 1 shows a flow diagram of the device object of the present invention.

With reference to figure 1, numeral 1 indicates the filter device, object of the present invention, comprising a first analog to digital signal converter 2, a numeric processing unit 5 and a second digital to analog signal converter 8.

The first analog to digital signal converter 2 is provided with an input port 3 for the analog signal having a predetermined maximum frequency and with an output port 4 for the signal converted in digital format.

The numeric processing unit 5, preferably of programmable kind of the so-called FPGA type, is equipped of a respective input port 6 in data communication with the output port 4 for the signal converted in digital format, and it is provided with a respective output port 7 for the processed digital signal.

The second digital to analog signal converter 8 has an input port 9 for the processed digital signal and an output port for the signal 10 converted to analog format.

During the operation of the digital filter device, the numeric processing unit 5 processes the digital signal in order to attenuate or to eliminate the components with frequency lower than a first predetermined minimum threshold and/or the components with frequency higher than a second predetermined maximum threshold.

The first converter 2 has a sampling frequency equal to or higher than the double of the predetermined maximum frequency of the analog signal at the respective input port 3.

The signal converters, first 2 and second 8, and the numeric processing unit 5 have, furthermore, respective input port 11, 12, 13 for one common time base clock 14.

This latter generates a synchronic signal for the signal converters, first 2 and second 8, and for the numeric processing unit 5 on the base of a external periodical signal 22.

It is provided a port 20 of the numeric processing unit 5 connected in a bi-directional manner to a control unit 15 and fit to modify the filtering characteristics through the control of the processing of digital signal made by the numeric processing unit 5. In particular, the control unit can activate and deactivate the precorrection of linear distortions and operate the setting of the bandwidth.

The device comprises also a data input port 21 of the numeric processing unit 5 which is connected to receive data from a memory unit 16 provided with data and controlled by the control unit 15. The memory unit 16 can memorize pairs of precorrection curves, each of them consists of one amplitude precorrection curve and one of group delay; such curves can be retrieved by the control unit 15. In the memory unit 16 is memorized also the set up bandwidth and the index of the selected precorrection curves, so that in case of discontinuity of power supply or of reset the initial operational conditions can be re-established.

There are remote communication means 17 bi-directionally connected to the control unit 15 for programming and for remote controlling the device 1. Such remote communication means 17 comprise ports and controllers for serial and/or parallel lines such as RS 232 and RS 485 and/or TIA/EIA-899 (M-LVDS).

The device furthermore comprises power supply and reset means 18. A key on the board card or the control unit 15 can activate said reset means 18.

When an analog signal has frequency higher than the half of the maximum sampling frequency of the first converter 2, a downward frequency converter 30 is provided up-stream to the input port 3 for analog signal and an upward frequency converter 31 is provided down-stream to the output port 10 of the converted analog signal. Said downward 30 and upward 31 frequency converters are of standard Intermediate Frequency kind.

An advantage of the present invention is to provide filter device almost free from attenuation and with a very small propagation delay.

Other advantage is to provide an adjustable form factor filter device with adjustable that is independent from the band and that can equalize the amplitude variations and signal transit time.

Further advantage is to provide a device that does not need conversions, frequency transpositions or analog demodulations of signal.

## Claims

1. Filter device **characterized in that** it comprises at least:
- a first analog to digital signal converter (2) provided with a analog signal input port (3) having a predetermined maximum frequency and with an output port (4) for the signal converted in digital format;
- a numeric processing unit (5) provided with a respective input port (6) in data communication with the output port (4) for the digital converted signal and with a respective output port (7) for the elaborated digital signal;
- a second digital to analog signal converter (8) provided with an input port (9) for the digital signal elaborated and with an output port (10) for the signal converted into analog format;
in which the numeric processing unit (5) elaborate the digital signal to attenuate or to eliminate the components with frequency lower than a first determined minimum threshold and/or the components with frequency higher than a second determined maximum threshold.

2. Device according to claim 1 **characterized in that** the signal converters, first (2) and second (8), and the numeric processing unit (5) have respective input ports (11, 12, 13) for a common time base (14).

3. Device according to claim 1 **characterized in that** the numeric processing unit (5) is programmable and is of the so called FPGA type.

4. Device according to claim 3 **characterized in that** a port (20) of the numeric processing unit (5) is bi-directionally connected to a control unit (15) fit to modify the filtering characteristics by means of the elaborating process control of the digital signal executed by the numeric processing unit (5).

5. Device according to claim 4 **characterized in that** a data input port (21) of the numeric processing unit (5) is connected to receive data from a memory unit (16) provided with data e controlled by the control unit (15).

6. Device according to claim 4 **characterized in that** it comprises remote communication means (17) bi-directionally connected to the control unit (15) for programming and remote command of the device 1.

7. Device according to claim 6 **characterized in that** the remote communication means (17) comprise ports and controllers for serial and/or parallel lines.

8. Device according to claim 1 **characterized in that** it comprises power supply and reset means (18).

9. Device according to claim 1 **characterized in that** the first converter (2) has a sampling frequency equal to or higher than the double of the predetermined maximum frequency of the analog signal at the respective input port (3).

10. Device according to claim 9 **characterized in that** when an analog signal has frequency higher than the half of the maximum sampling frequency of the first converter (2), a downward frequency converter (30) is provided up-stream to the input port (3) for analog signal and an upward frequency converter (31) is provided down-stream to the output port (10) of the converted analog signal.

11. Device according to claim 10 **characterized in that** the downward (30) and upward (31) frequency converters are of standard Intermediate Frequency kind.

12. Device according to claim 2 **characterized in that** the common time base (14) generates a synchronic signal at least for the signal converters first (2) and second (8), and for the numeric processing unit (5) on the base of a external periodic signal (22).
